# EUROPEAN PATENT SPECIFICATION

(11) **EP 1 189 016 B1**
(45) Date of publication and mention of the grant of the patent: **22.04.2009**
(21) Application number: 00870203.7
(22) Date of filing: 15.09.2000
(51) Int. Cl.: G01B 7/34

(54) **Method of manufacturing mounted AFM-probes by soldering**
Verfahren zur Herstellung montierter AFM-Sonden durch Löten
Méthode de fabrication de sondes assemblées par brasage

(43) Date of publication of application: 20.03.2002
(73) Proprietor: INTERUNIVERSITAIR MICRO-ELEKTRONICA CENTRUM VZW, 3001 Heverlee (BE)
(72) Inventor: Hantschel, Thomas, 39439 Amesdorf (DE); Vandervorst, Wilfried, 3210 2800 Mechelen (BE)
(74) Representative: pronovem

(56) References cited:
- DE-A- 4 208 988
- DE-A- 19 738 399
- US-A- 5 006 792
- US-A- 5 173 574
- US-A- 5 234 151
- US-A- 5 316 205
- US-A- 5 451 174
- US-A- 5 478 700
- US-A- 5 791 552
- US-A- 5 994 160
- ALBRECHT T R ET AL: "MICROFABRICATION OF CANTILEVER STYLI FOR THE ATOMIC FORCE MICROSCOPE" JOURNAL OF VACUUM SCIENCE AND TECHNOLOGY: PART A,US,AMERICAN INSTITUTE OF PHYSICS. NEW YORK, vol. 8, no. 4, 1 July 1990 (1990-07-01), pages 3386-3396, XP000148046 ISSN: 0734-2101

## Description

### Field of the invention

The present invention is generally related to scanning microscopes, such as tunnelling or atomic force microscopes and more particularly to the mounting onto holder chips of the probes used in these microscopes.

### Background and state of the art

Atomic force microscopy (AFM) is extensively used in microelectronics as an electrical characterisation tool in order to determine the carrier distribution inside semiconductor devices. Electrically conductive probe tips are needed for these measurements and therefore different probe concepts have been developed. Such probe tips are integrated into cantilever beams and can be divided into two classes: coated Si tips, and pyramidal metal or diamond tips. In "The fabrication of a full metal AFM probe and its applications for Si and InP device analysis", T. Hantschel et Al., Proc. Micromachining and Microfabrication conference, 1999 a method for manufacturing full metal probes, applying the so-called moulding technique, is disclosed. Prior to the mounting of the probe into a scanning microscope, the probe needs to be fixed to small holder chips with millimetre dimensions (e.g. 3mm long, 1.5mm wide and 0.3mm thick). In case of Si probes, i.e. a probe tip with a silicon cantilever, these holder chips can be formed out of the same wafer from which the Si tips and cantilevers are manufactured. This is however not possible for pyramidal probe tips made by the so-called moulding technique, where the holder chip has to be attached in a separate step to one longitudinal end of the cantilever. The electrical probes, comprising a cantilever beam with integrated pyramidal metal or diamond tips, have to be mounted to small holder chips before they can be used in electrical atomic force microscopy (AFM).

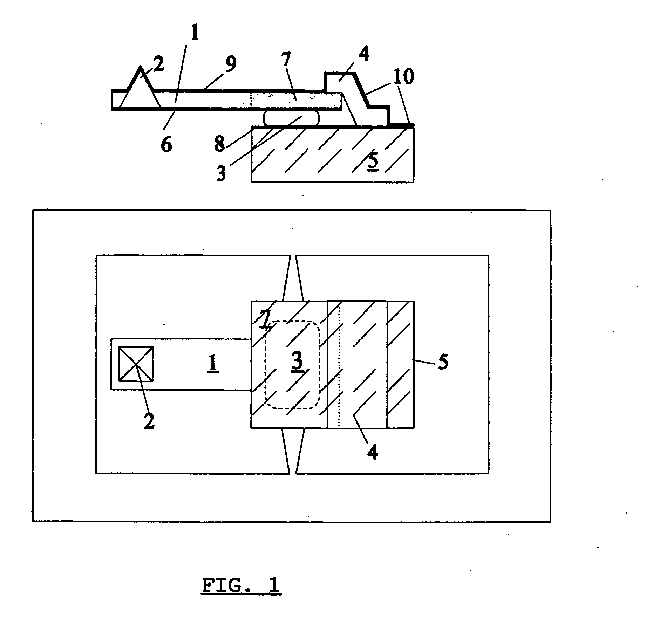

Three solutions have been developed so far for the mounting of moulded AFM probes. In one method a glass wafer is anodically bonded to the Si wafer and the holders are then diced by sawing. This method requires for example high temperature processing, thorough cleaning of the glass surface, separate voltage source. This mounting procedure is well known for the fabrication of Si₃N₄ probes as disclosed by T.R. Albrecht et Al. in, "Microfabrication of cantilever styli for the atomic force microscope", J. Vac. Sci. Technol. 8(4), pp. 3386-3396, 1990. In a second method holder chips are formed by locally electroplating the Si wafer. Full metal probes with integrated holders have been manufactured in this way as disclosed by J.P. Rasmussen et Al. in "Fabrication of an all-metal atomic force microscope probe", Proc. Of Transducers '97, pp. 463-466, 1997. Several layers of resist have to be spun on the substrate in order to form a mould having the desired thickness to form in this mould the holder chip by electroplating. In a third method the holder chips are glued to thin contact areas which are formed during cantilever etching. C. Mihalcea et Al. illustrates this application in "Fabrication of monolithic diamond probes for scanning probe microscopy applications", Appl. Phys., A66, pp. S87-S90, 1998. Due to its simplicity gluing is today mostly used for the mounting of electrical AFM probes made by the so-called moulding technique. Figure 1 illustrates the mounting of the probe, comprising the contact area (7), the probe tip (2) and cantilever (1) to a Si holder chip (5). In case of a non-conductive glue (3) a silver paint dot (4) bridges the step between contact area (7) and chip (5). An additional metal coating (6) on the tip side is needed in order to obtain a good electrical connection between tip and chip.

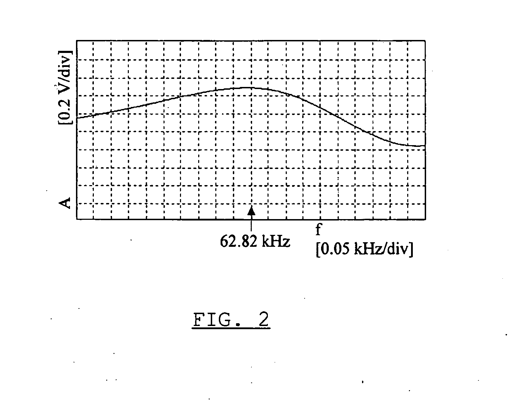

Moulded AFM probes, e.g. full metal probes or Si cantilevers with integrated metal and diamond tips according to the prior art, were mounted to holder chips by gluing. This procedure has three main disadvantages:
- The non-conductive glue requires an additional thin metal coating (6) on the tip side. This additional metal coating increases the tip radius slightly leading to a smaller resolution of the scanned image.
- The fast-drying glue does only allow separate probe mounting as the solder chips have to be mounted one at a time. This method is thus not very suitable for mass fabrication of probes for electrical scanning microscopes.
- The thus mounted probe suffers from a low mechanical stability. The probe can e.g. often only be used in contact mode AFM because sharp resonance peaks as required in tapping mode will normally not be obtained with glued probes. In tapping mode the probe is in intermittent contact with the sample and oscillates at a frequency close to its resonance frequency. This method will reduce the wear of the probe tip and extend the lifetime of the probe. The gluing connection was often not rigid enough for tapping mode application. The poor resonance behaviour of the glued probes might be caused by two factors: a high loss of energy due to the use of flexible glue, and a free-standing probe which is only fixed in the middle to the holder chip. More rigid glue might reduce the energy losses but other factors like viscosity and drying time of the glue need also to be matched. Figure 2 shows a typical resonance curve obtained with test glued probes. Multiple unsharp or dull peaks were typically observed instead of one sharp peak. After magnification it can be seen that the main peak is very broad and therefore not suited for tapping mode measurements.

Other disadvantages of the glue technique are the difficulty of fixing the probe over the whole overlap region of contact area (7) and the holder chip (5) and the removal of the excess glue after attaching the holder chip. The excess glue was often found back on the cantilever after mounting.
Document US5994160 is related to a process for manufacturing micromechanical components suitable for Atomic Force Miscroscopy. A probe tip/cantilever assembly is attached to a silicon support by adhesive bonding or soldering.

### Aims of the invention

An aim of the present invention is to disclose a method for mounting holder chips to probes, used in scanning microscopes, providing a direct electrical connection between the cantilever with probe tip and the holder chip. This method does not require additional processing after mounting of the holder chip to establish such electrical connection.

A further aim of the present invention is to establish a connection between the holder chip and the probe such that during the step of forming said connection the original or as-deposited position of the holder chip with respect to the probe remains essentially the same.

A further aim of the present invention is to disclose a method to mount holder chips to probes without substantially changing the tip geometry and conducting properties of tip and cantilever.

A further aim of the present invention is to obtain a rigid probe-holder chip connection having good mechanical properties fit for e.g. tapping mode AFM. The connection between holder chip and contact area is established substantially over the overlap region of both parts.

Another aim of the present invention is to disclose a method to mount a cantilever or a cantilever-holder chip assembly to a probe tip.

Another aim of the present invention is to obtain probes with a soldered connection between holder chip and cantilever, having the holder chip essentially at is original position with respect to the cantilever. Holder chip and cantilever are positioned along the same longitudinal axis.

### Summary of the invention

The present invention, as defined in claim 1, discloses a method for mounting a holder chip to a probe for Atomic Force Microscopy (AFM), said probe comprising a cantilever and probe tip. This method comprises the steps of:
- applying a solderable material on the holder chip;
- applying a solder paste to the contact area;
- mounting the holder chip to the contact area on top of the solder paste; and
- soldering the holder chip to the probe
The method is characterized in that said solder paste is a SnBi paste. Preferred embodiments are disclosed in the dependent claims.

In a first embodiment the solderable material deposited on the holder chip and the contact area is disclosed. Preferably the same solderable material is deposited on both parts. The solderable material can be a stack of Ti:W, Au and can further comprise Ni.

In a second embodiment the solder paste is disclosed. This solder paste can comprise a flux. The solder paste should fix the holder chip after depositing the holder chip to the paste, such that the position of the holder chip relative to the contact area remains essentially unchanged during the further soldering of the holder chip. The solder paste can be based on IPA or water-soluble fluxes. The solder paste can also be fluxless.

In a third embodiment the step of establishing the solder connection between the holder chip and the contact area is disclosed. Preferably the assembly of holder chip on solder paste on contact area is heated on a hotplate. During the heating step a solder connection between holder chip and contact area is established The solder will wet substantially the whole overlap region but will not flow outside this region.

### Short description of the drawings

All drawings are intended to illustrate some aspects and embodiments of the present invention. Devices and fabrication steps are depicted in a simplified way for reason of clarity. Not all alternatives and options are shown and therefore the invention is not limited to the content of the given drawings. Like numerals are employed to reference like parts in the different figures.

Fig. 1 represents a conventional gluing method of mounting the probe to a holder chip, illustrated by cross sectional view (top) and top view (bottom).

Fig. 2 represents the resonance behaviour of a glued probe with detained view. The amplitude (A) is given as function of the drive frequency (f).

Fig. 3 is a schematic representation of the mounting scheme according to one embodiment of the present invention.

Fig. 4 represents the wetting of solder paste on a metallisation stack according to an embodiment of the invention.

Fig. 5 represents the sticking force (F) in mN vs. substrate temperature (t) in °C for 5 different solder pastes: SnPbAg2 (21), SnAg3.5 (22), SnBi58 (23), SnCul (24), SnAg3.8Cu0.7 (25).

Fig. 6 represents the removal of flux from a test chip after soldering according to an embodiment of the invention.

Fig. 7 represents a comparison of holder chips mounted to the probe by gluing (a) or by soldering (b, c) according to an embodiment of the invention.

Fig. 8 represents the resonance behaviour of a soldered Si cantilever with integrated metal tip according to an embodiment of the invention.

Fig. 9 represents I-V measurements on a Pt sample using a full metal probe mounted according to an embodiment of the invention.

Fig. 10 represents the mounting of the probe tip to the cantilever-holder chip assembly according to an embodiment of the present invention.

### Detailed description of the invention

In relation to the appended drawings the present invention is described in detail in the sequel.

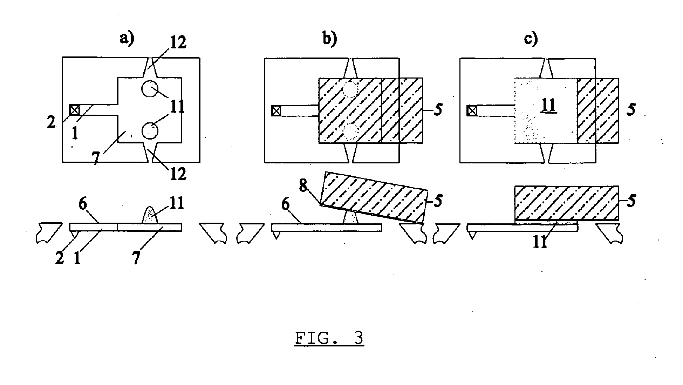

The present invention discloses a method for mounting holder chips to probe. This method comprises the steps of:
- applying a solderable material (8) on the holder chip (5);
- applying a solder paste (11) to the contact area (7) (figure 3a);
- mounting the holder chip (5) to the contact area (7) on top of the solder paste (11) (figure 3b); and
- soldering the holder chip to probe (figure 3c).

This method can further comprise the step of applying a solderable material (6) to the probe. The mounting of the holder chip to the probe can comprise the step of aligning the holder chip to the boundaries of the contact area, such that the holder chip border substantially coincides with the contact area boundary at the cantilever side. The holder chip can project from the contact area at the opposite side. The holder chip is positioned along the longitudinal axis of the cantilever. The step of applying a solder paste to the contact area can comprise the step of applying at least one dot, preferably two dots, of the solder paste to the contact area or to the holder chip surface that will be connected to the probe.

The contact area of the probe is defined as the extension of the cantilever along its longitudinal axis opposite the probe tip. The solder paste will preferably be deposited on the surface of the contact area opposite the tip side of the cantilever. The holder chip can be smaller or larger than the contact area. The holder chip preferably coincides substantially with the contact area.

A first embodiment discloses the solderable material used in the metallisation scheme of the holder chip and the probe. Preferably the same metallisation scheme is used for both parts. For soldering AFM probes it is necessary to have a solderable material on both the holder chip and the probe. This solderable material must be wetted very well by the solder paste in order to have a good contact substantially all over the contact area. Moreover essentially only the contact area should be wetted by the solder paste to avoid excess solder paste present outside the contact area. Such excess solder paste needs to be removed otherwise. This solderable material can already be present on the surfaces of the holder chip and probe that will be connected by the soldering or needs to be deposited at least on these surfaces in a separate step.

Gold (Au) surfaces are known to wet very well by molten solder. Gold can be present at the backside of the cantilever, opposite the tip side of the cantilever. This gold layer is deposited at the end of the probe manufacturing process in order to enhance the reflection of the laser beam in the AFM and to achieve good electrical connection between tip and holder. This gold layer can be deposited on top of a Ti:W metal stack. A similar metal stack can also applied on the holder chip and can comprising 20nm Ti:W and 100nm Au where the Ti:W layer serves as adhesion layer to the underlying substrate, e.g. Si, of the holder chip.

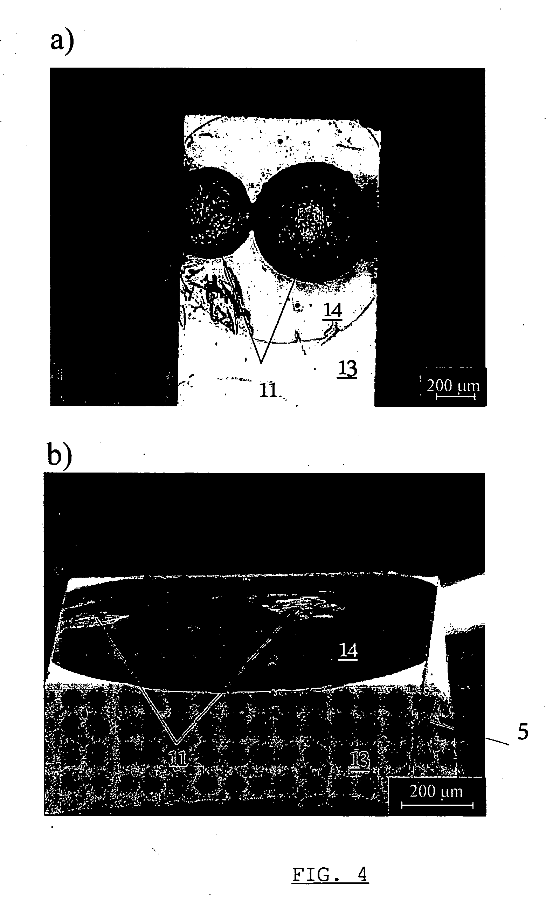

It is known that the dissolution rate of Au in Sn-containing solders is always extremely high due to the strong interaction between Au and Sn. Therefore, bilayer metallization schemes have been developed with a thin Au layer on the top surface and a second layer as bottom layer. This second layer must at least be soldered moderately and has to have a low dissolution rate in Sn. An example of a material that can be used as second layer is Ni. As an example of such bilayer metallisation scheme a stack of 20nm Ti:W, 45nm Ni as second layer and 100nm Au as top layer was applied. Figure 4a en 4b show a test chip metallized according to this embodiment, soldered according to other embodiments of this invention. Two droplets of solder paste (11) were placed onto the chip (5). Fig 4a was taken under the optical microscope and shows that the Ti:W is not exposed to the molten solder. Only Au 13) can be seen around the soldered areas. The Au underneath the bump dissolved quickly into the solder thereby exposing the second, Ni, layer to the melted solder. As can be seen in the SEM image (fig 4b), the surface was wetted very well and the solder (11) spread out over the surface.

These experiments have shown that a metallisation scheme comprising 20nm Ti:W, 45nm Ni and 100 nm Au is well suited for probe mounting. This metal stack can be used as a standard metallisation scheme on both holder chip and probe. In the case of full metal probes, processed according the prior art, such an additional metallisation step is not required for the probe because Ni, preferably in the range of 10 to 15 µm thick, is already present as it is part of the metal cantilever. Therefore such probes can be soldered directly.

In a second embodiment the solder paste used in the mounting of holder chips to the probe is disclosed. Two main requirements need to be fulfilled by the solder paste in order to be applicable in AFM probe mounting. First, the stickiness of the paste should be sufficient high at elevated temperatures to prevent the holder chip being moved substantially out of its as-deposited or original position during soldering. Secondly, the flux should be easily removable from the probe after soldering because the flux could contaminate the tip during soldering and result in a lower overall conductivity of the probe. The melting or solder temperature of the solder paste should be low enough to avoid deformation of the probe, e.g. bending of the cantilever.

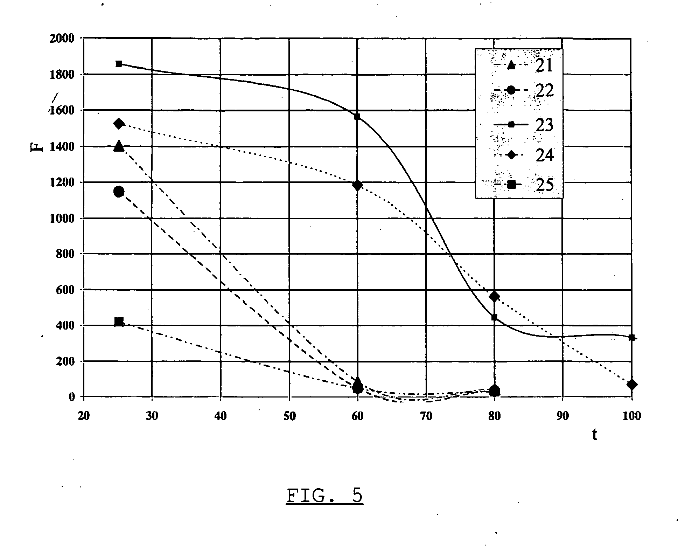

A solder paste is a suspension of solder powder particles in flux (14), to which special agents have been added. Many different solder pastes are available on the market and are often optimised for one specific application. The stickiness or adherence of the different pastes can be evaluated with a tackiness tester TK-1 from Malcom that is able to measure the sticking force of such pastes at different temperatures. For the purpose of teaching such a sticking test is disclosed. Five solder paste bumps with a diameter of about 6mm and a height of 0.2 mm were printed onto a ceramic substrate. The substrate was then heated up to the desired temperature. A steel pin of about 6 mm in diameter was lowered down and penetrated the paste bump with a given force. The steel pin was finally rejected and the sticking force was measured. This measurement was repeated five times for each temperature and the mean value was calculated from the 5 measurements. Each paste was measured at 25°C, 60°C and 80°C. Two pastes which showed a remarkable adherence force still at 80°C were also measured at 100°C and the SnBi58 (23) paste also at 120°C. Figure 5 illustrates the results of these measurements. It shows the sticking force F as a function of the applied temperature t. Each paste has a different sticking force at room temperature. The SnAg3.8Cu0.7 (25) paste has the lowest, the SnBi58 (23) paste has the highest sticking force. As the temperature is increased, the pastes can be clearly divided into two groups. For one group (SnPbAg2 (21), SnAg3.5 (22), SnAg3.8Cu0.7 (25)) the sticking force rapidly decreases with temperatures and there is no stickiness anymore at 80°C, indicating the flux solvent is completely evaporated. The other group (SnBi58 (23), SnCu1 (24)) shows high stickiness also above 80°C. It is not surprising that the two groups of pastes are stemming from two different suppliers. The pastes are based on different flux systems that are obviously optimised for different applications. The SnBi58 (23) paste has shown the highest stickiness of all tested pastes. This solder paste melts already at a temperature of 139°C, such temperature being suitable for the mounting of full metal probes. Metal cantilevers made out of Ni often bend after exposing them to temperatures above 200°C.

The SnBi58 solder paste can be chosen as a preferred standard paste for probe mounting according to the present invention mainly due to its high stickiness at higher temperatures. The other pastes were also tested for probe mounting but in this case about 50% of the holder chips changed their position during the soldering step.

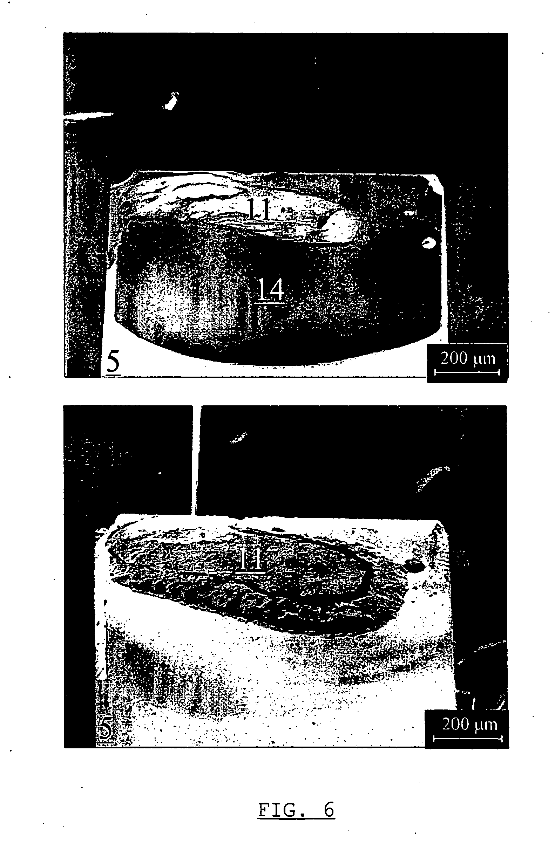

The flux (14) of the SnBi58 paste was removed after the soldering step by rinsing the sample in hot isopropanol (IPA, θ=60°C) for a few minutes. The cantilever can also be cleaned with cold IPA or acetone, if applied for an appropriate cleaning time. This cleaning time can be longer compared to the IPA cleaning procedure. Solder pastes are available which are based on water-soluble fluxes. Cleaning the cantilever in warm water might be sufficient to remove such water-soluble fluxes. Figure 6a shows a test chip (5) after the soldering step imaged by scanning electron microscopy (SEM). It can be seen that the solder bump (11) is surrounded by the flux (14) Figure 6b shows the same test chip (5) after the IPA rinse. As can be seen, the flux (14) was completely removed during the cleaning step in IPA.

Using screen-printing technology for the deposition and patterning of the solder paste can automate this step of the soldering procedure. Such screen printing technology is a well-established method in thick film and solar cell technology.

In a third embodiment the method of soldering the holder chip to the probe is disclosed. During the step of soldering of the holder chip to the probe mechanical vibrations, e.g. caused by transport of the devices, should be avoided as such vibrations might cause the holder chips to move away from their as-deposited position. AFM probes are only about 10 to 15 um thick and are therefore very sensitive to such mechanical vibrations.

Different soldering techniques can be used for the soldering step; such as reflow furnaces, vapour phase heating, and hotplates. In the reflow system of LP-Thermtech AG e.g. the heat is supplied from above. The substrates comprising the probes and the positioned holder chips on top, are moved by a conveyor through different temperature zones, in each of which the temperature can be independently controlled. Soldering can be done possible in a nitrogen atmosphere. Mechanical vibrations of the chain will cause the holder chip to move.

Vapour phase soldering was developed in the early 1970's. In this method the parts being soldered are exposed to saturated vapour at a temperature being the same as the boiling point of the fluid used. Therefore, this method does not need any temperature controller. Examples of such vapour phase systems are IBL-Lötechnik (VPP-M 600) which is more suited for high throughput, and the vapour phase Quicky 300 from Asscon Systemtechnik-Elektronik GmbH which is more suited for research. Experiments have shown that the industrial system caused shifting of the probes due to small mechanical shocks which occurred when the substrates were lowered down automatically in small steps into the vapour zone. Good results were obtained with the Quicky-300 system. In this system the substrates are not moved into the vapour zone but the vapour zone rises from below and reaches the substrates. After soldering the fluid is cooled rapidly causing the lowering of the vapour zone again. This indicates that best results are obtained when the probes are not moved at all during the soldering step.

A digital hotplate can also be used for supplying the heat required for melting the solder paste. An example of such a hotplate is the RET control-visc from IKA Labortechnik. Although hotplate soldering is not used for Surface Mounted Devices (SMD), it is a method frequently used in microelectronics, e.g. resist baking, heating of chemicals. Soldering was done by putting the substrate, e.g. a Si substrate, with the test chips onto the hotplate and heating it up to a temperature about 20°C above the melting temperature of the solder alloy. After melting of the paste and an additional waiting time of about 5 to 10 seconds, the wafer was slowly removed from the hotplate. Using the SnBi58 solder paste nearly all chips stayed in their true position. The digital hotplate allows accurate temperature control and a desired temperature profile can also easily be adjusted via a computer. Although wafers have to be soldered one by one, a soldering cycle takes only about 5 minutes and therefore a reasonable amount of wafers can be soldered in relatively short time.

A preferred embodiment of the present invention comprises the use of a metallisation scheme of Ti:W+Ni+Au, SnBi58 solder past and soldering on a digital hotplate.

Figure 3a to 3c show the mounting procedure schematically. An optical microscope was used for positioning control during the different steps. The probe is covered at least at its backside, i.e. opposite the tipside of the cantilever, with 20nm Ti:W, 45nm Ni and 100nm Au. Two droplets of solder paste (11), i.e. SnBi58, were deposited on the contact area (7) of the probe using the end of a thin metal wire that was dipped into the paste before (figure 3a). The stickiness of the paste allows the deposition of only a small portion of paste each time the wire touches the contact area. It is very advantageous to deposit two small droplets of paste on the contact area instead of only one big droplet. If only one droplet was used the holder chip is likely to rotate and move way from it as-deposited position. If at least two droplets are deposited near the edge of the contact area, however, the chip is held in its original position during soldering. It is believed that the solder bumps neutralise their rotation. The droplets are preferably deposited on opposite sides of the contact area, at a spacing as large as possible.

In the second step, the metallised (6) Si chips (5) (3mm long, 1.2mm wide and 0.6mm thick) were placed onto the probe using a tweezer. The chip (5) was positioned in such a way that the chip end and the fixed cantilever end are lying on top of the other having the holder chip cover substantially the contact area. The positioning of the holder chips can be automated by fabricating holder chip wafers that are then placed onto the probe wafer using a wafer bonding tool. The holder chips have the same metallisation stack as the probe. The paste bumps were holding the chips in their original position enabling handling of the wafer. Strong mechanical shocks can however move the chips out of position and should therefore be prevented. In the third step, the substrate was placed on the digital hotplate which was then heated up to 159°C, the melting temperature of SnBi58 being 139°C. At the moment the solder melted, the chips were sucked closely to the contact area. The solder will wet substantially the whole overlap region very well but will not flow outside this area. This feature of the mounting procedure prevents the cantilever from also being covered by solder which would not be acceptable. In some cases it was observed that cantilever and tip were covered by flux during soldering. Therefore, a cleaning step in hot IPA as described was done. Finally, the mounted probes were removed from the wafer by breaking the two bridges (12).

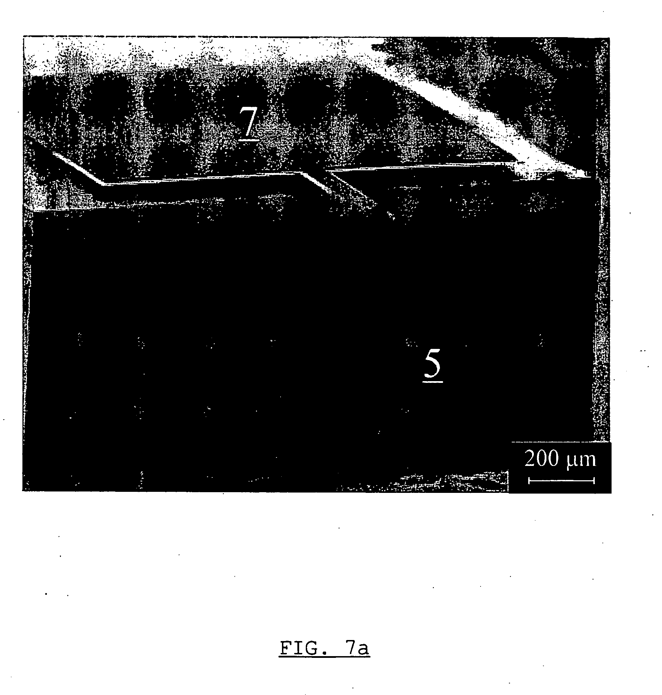

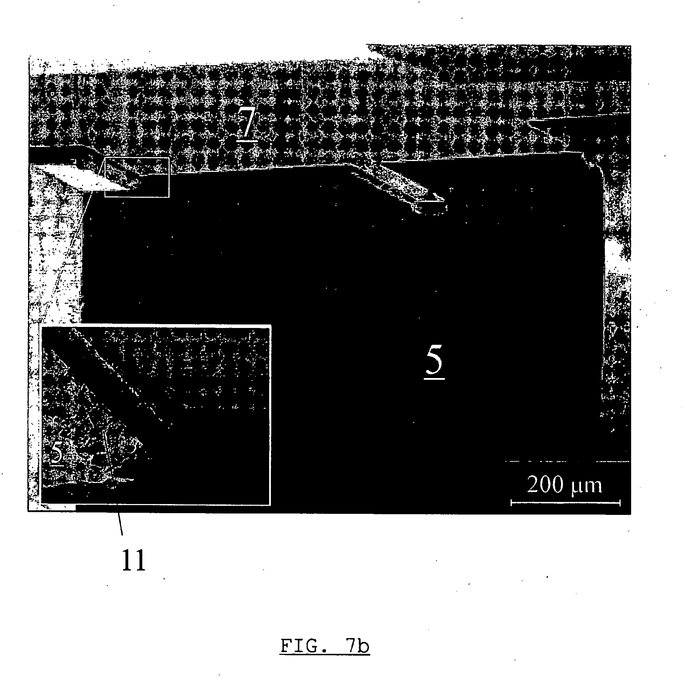

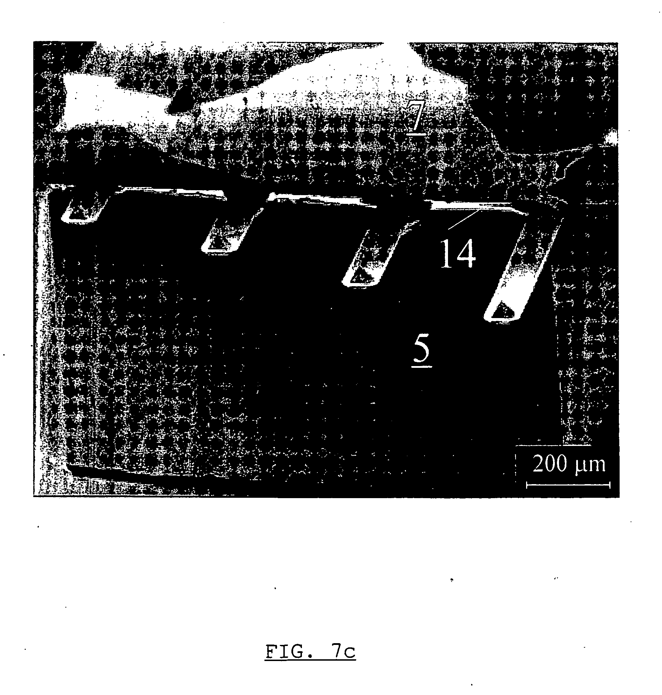

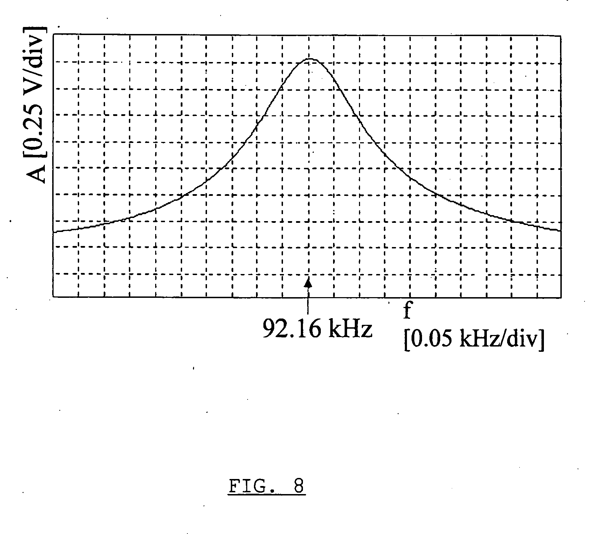

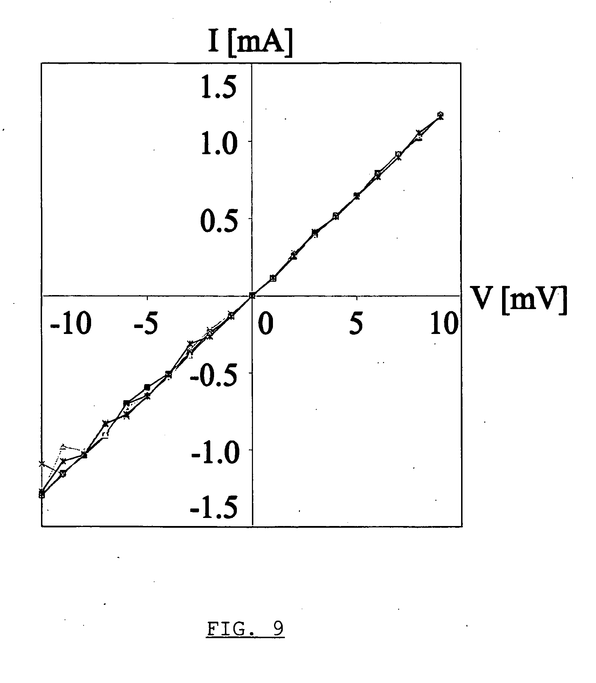

Figure 7b shows a soldered Si cantilever with integrated metal tip. It can be clearly seen that the solder (11), substantially fills the space between holder chip (5) and contact area (7). Figure 7a shows for comparison a glued probe. Figure 7c shows a soldered full metal probe with four cantilever beams made out of Ni prior to the flux (14) removal step. No additional metallisation layer is required in case of such full metal probes and therefore the solder chips can be soldered directly. It can be seen that there is still a lot of space between contact area (7) and chip (5) and that these two surfaces are not drawn as tight to each other as in the soldered connection. Furthermore, this space is not filled completely by the glue. This incomplete filing resulted in poor resonance behaviour of such probes in tapping mode AFM as was shown in figure 2 contrary the good resonance properties of the soldered chips as shown in figure 8 for a Si cantilever with integrated metal tip. The direct electrical connection between the cantilever and the holder chip formed by the solder results in a low probe resistance as shown in figure 9. A probe resistance of 8 - to 20 ohm was obtained whereas Si probes coated with metal layers, as shown in figure 1, will show higher resistance values.

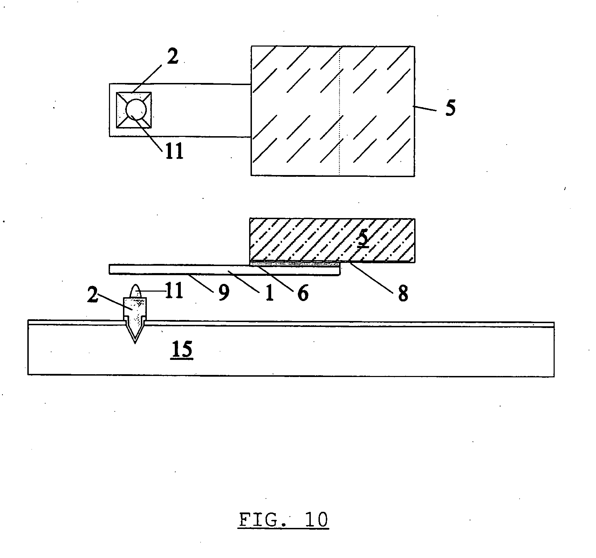

In another aspect of the invention the probe tip can be attached to the cantilever or the cantilever - holder chip assembly using the methods disclosed in the other embodiments of this invention. Figure 10 illustrates such a mounting of the probe tip to the cantilever.

## Claims

1. A method of mounting a holder chip to the contact area of a probe for Atomic Force Microscopy (AFM), said probe comprising a cantilever (1) and probe tip (2), the method comprising the steps of:
- applying a solder paste (11) to said contact area (7) of said probe;
- depositing said holder chip (5) to said solder paste on top of said contact area (7); and
- soldering said holder chip (5) to said probe
**characterized in that** said solder paste is a SnBi paste.

2. A method as recited in claim 1, further comprising the step of depositing a solderable material (6) at least on said contact area of said probe before the step of applying a solder paste.

3. A method as recited in claim 1, further comprising the step of depositing a solderable material (8) on said holder chip (5) prior to the step of depositing said holder chip to said solder paste.

4. A method as recited in claim 1 wherein said step of depositing said holder chip to said solder paste further comprises the step of aligning said holder chip co-axial along the longitudinal axis of said cantilever and to the boundary of said contact area.

5. A method as recited in claim 2 and 3 wherein said solderable material is the same on said holder chip and on said contact area.

6. A method as recited in claim 5 wherein said solderable material comprises a stack of a Ti: W adhesion layer and an Au layer.

7. A method as recited in claim 6 wherein said stack further comprises a top layer of Ni.

8. A method as recited in claim 1 wherein said solder paste is such that it retains its stickiness during the further process of soldering said holder chip to said contact area, such that the relative position of said holder chip to said contact area remains essentially the same.

9. A method as recited in claim 8 wherein said solder paste is deposited as two separate dots at opposite sides of said contact area.

10. A method as recited in claim 9 wherein said solder paste is used in flux soldering.

11. A method as recited in claim 10 wherein said solder paste is a SnBi paste having a stickiness of more than 300 mN at temperatures above 70°C.

12. A method as recited in claim 1 wherein said step of soldering said holder chip to said probe comprises the step of heating said holder chip, solder paste and said probe assembly without substantially changing the relative position of said holder chip with respect to said contact area.

13. A method as recited in claim 12 wherein said heating is done on a hotplate.

14. A method as recited in claim 1, wherein said solder paste is a SnBi58 solder paste.

15. A holder chip-probe assembly for Atomic Force Microscopy probes comprising:
- a holder chip (5):
- a probe consisting of a probe tip (2), a cantilever (1) and a contact area (7); and
- a solder connection between said holder chip and said contact area, **characterized in that** said solder connection comprises SnBi.

16. A probe tip-cantilever assembly for Atomic Force Microscopy probes, comprising:
- a probe tip (2);
- a cantilever (1) mounted to a holder chip (5); and
- a solder connection between said probe tip and said cantilever, **characterized in that** said solder connection comprises SnBi.

## Patentansprüche

1. Verfahren zum Anbringen eines Haltechips auf der Kontaktfläche einer Sonde für die Rasterkraftmikroskopie (AFM), wobei die Sonde ein Cantilever (1) und eine Sondenspitze (2) umfasst, wobei das Verfahren folgende Schritte umfasst:
- Auftragen einer Lötpaste (11) auf die Kontaktfläche (7) der Sonde ;
- Ansetzen des Haltechips (5) auf die Lötpaste oben auf der Kontaktfläche (7) ; und
- Löten des Haltechips (5) an die Sonde,
**dadurch gekennzeichnet, dass** die Lötpaste eine SnBi-Paste ist.

2. Verfahren nach Anspruch 1, ferner umfassend den Schritt des Abscheidens eines lötbaren Materials (6) mindestens auf die Kontaktfläche der Sonde vor dem Schritt des Auftragens einer Lötpaste.

3. Verfahren nach Anspruch 1, ferner umfassend den Schritt des Abscheidens eines lötbaren Materials (8) auf den Haltechip (5) vor dem Schritt des Absetzens des Haltechips auf die Lötpaste.

4. Verfahren nach Anspruch 1, wobei der Schritt des Absetzens des Haltechips auf die Lötpaste ferner den Schritt umfasst, der darin besteht, den Haltechip koaxial entlang der Längsachse des Cantilevers und zur Grenze der Kontaktfläche auszurichten.

5. Verfahren nach Anspruch 2 und 3, wobei das lötbare Material auf dem Haltechip und auf der Kontaktfläche das gleiche ist.

6. Verfahren nach Anspruch 5, wobei das lötbare Material einen Stapel umfasst, der aus einer Ti:W-verbundschicht und einer Au-Schicht besteht.

7. Verfahren nach Anspruch 6, wobei der Stapel ferner eine obere Schicht aus Ni umfasst.

8. Verfahren nach Anspruch 1, wobei die Lötpaste derart ausgestaltet ist, dass sie ihre Klebrigkeit während des weiteren Lötprozesses des Haltechips auf der Kontaktfläche beibehält, so dass die relative Position des Haltechips zur Kontaktfläche im wesentlichen die gleiche bleibt.

9. Verfahren nach Anspruch 8, wobei die Lötpaste als zwei getrennte Punkte auf entgegengesetzten Seiten der Kontaktfläche abgeschieden wird.

10. Verfahren nach Anspruch 9, wobei die Lötpaste zum Weichlöten verwendet wird.

11. Verfahren nach Anspruch 10, wobei die Lötpaste eine SnBi-Paste ist mit einer Klebrigkeit von mehr als 300 mN bei Temperaturen von über 70 °C.

12. Verfahren nach Anspruch 1, wobei der Schritt des Lötens des Haltechips an die Sonde den Schritt umfasst, der darin besteht, den Haltechip, die Lötpaste und die Sondenanordnung zu erhitzen, ohne dabei die relative Position des Haltechips im Verhältnis zur Kontaktfläche im Wesentlichen zu verändern.

13. Verfahren nach Anspruch 12, wobei das Erhitzen auf einer Heizplatte erfolgt.

14. Verfahren nach Anspruch 1, wobei die Lötpaste eine SnBi58-Lötpaste ist.

15. Haltechip/Sondan-Anardnung für Rasterkraftmikroskopiesonden, umfassend:
- einen Haltechip (5) ;
- eine Sonde, die aus einer Sondenspitze (2), einem Cantilever (1) und einer Kontaktfläche (7) besteht; und
- einer Lötverbindung zwischen dem Haltechip und der Kontaktfläche,
**dadurch gekennzeichnet, dass** die Lötverbindung SnBi umfasst.

16. Sondenspitze/Cantilever-Anordnung für Rasterkraftmikroskopiesonden, umfassend:
- eine Sondenspitze (2);
- einen Cantilever (1), der auf einem Haltechip (5) angebracht ist; und
- eine Lötverbindung zwischen der Sondenspitze und dem Cantilever, **dadurch gekennzeichnet, dass** die Lötverbindung SnBi umfasst.

## Revendications

1. Procédé de montage d'une puce de support sur la zone de contact d'une sonde pour la microscopie à force atomique (AFM), ladite sonde comprenant un microlevier (1) et une pointe de sonde (2), le procédé comprenant les étapes consistant à :
- appliquer une pâte à braser (11) à ladite zone de contact (7) de ladite sonde ;
- déposer ladite puce de support (5) sur ladite pâte à braser au-dessus de ladite zone de contact (7) ; et
- braser ladite puce de support (5) à ladite sonde,
**caractérisé en ce que** ladite pâte à braser est une pâte Subi.

2. Procédé selon la revendication 1, comprenant en outre l'étape consistant à déposer un matériau brasable (6) au moins sur ladite zone de contact de ladite sonde avant l'étape consistant à appliquer une pâte à braser.

3. Procédé selon la revendication 1, comprenant en outre l'étape consistant à déposer un matériau brasable (8) sur ladite puce de support (5) avant l'étape consistant à déposer ladite puce de support sur ladite pâte à braser.

4. Procédé selon la revendication 1, dans lequel ladite étape consistant à déposer ladite puce de support sur ladite pâte à braser comprend en outre l'étape consistant à aligner ladite puce de support de façon coaxiale le long de l'axe longitudinal dudit microlevier et à la limite de ladite zone de contact.

5. Procédé selon les revendications 2 et 3, dans lequel le matériau brasable est le même sur ladite puce de support et sur ladite zone de contact.

6. Procédé selon la revendication 5, dans lequel ledit matériau brasable comprend une pile composée d'une couche d'adhésion Ti:W et d'une couche Au.

7. Procédé selon la revendication 6, dans lequel ladite pile comprend en outre une couche supérieure de Ni.

8. Procédé selon la revendication 1, dans lequel ladite pâte à braser est telle qu'elle retient son adhésivité pendant le reste du processus de brasage de ladite puce de support sur ladite zone de contact, de telle sorte que la position relative de ladite puce de support par rapport à ladite zone de contact reste essentiellement la même.

9. Procédé selon la revendication 8, dans lequel ladite pâte à braser est déposée comme deux points séparés sur des côtés opposés de ladite zone de contact.

10. Procédé selon la revendication 9, dans lequel ladite pâte à braser est utilisée pour le brasage de flux.

11. Procédé selon la revendication 10, dans lequel ladite pâte à braser est une pâte SnBi ayant une adhésivité de plus de 300 mN à des températures supérieures à 70 °C.

12. Procédé selon la revendication 1, dans lequel ladite étape consistant à braser ladite puce de support sur ladite sonde comprend l'étape consistant à chauffer ladite puce de support, la pâte à braser et ledit ensemble de sonde sans changer substantiellement la position relative de ladite puce de support par rapport à ladite zone de contact.

13. Procédé selon la revendication 12, dans lequel ledit chauffage est réalisé sur une plaque chauffante.

14. Procédé selon la revendication 1, dans lequel ladite pâte à braser est une pâte à braser SnBi58.

15. Ensemble puce de support/sonde pour sondes de microscopie à force atomique, comprenant :
- une puce de support (5) ;
- une sonde composée d'une pointe de sonde (2), d'un microlevier (1) et d'une zone de contact (7) ; et
- une connexion de brasage entre ladite puce de support et ladite zone de contact, **caractérisé en ce que** ladite connexion de brasage comprend du SnBi.

16. Ensemble pointe de sonde/microlevier pour sondes de microscopie à force atomique, comprenant :
- une pointe de sonde (2) ;
- un microlevier (1) monté sur une puce de support (5) ; et
- une connexion de brasage entre ladite pointe de sonde et ledit microlevier, **caractérisé en ce que** ladite connexion de brasage comprend du SnBi.
